# EUROPEAN PATENT APPLICATION

(11) **EP 1 225 138 A1**
(43) Date of publication of application: **24.07.2002**
(21) Application number: 01101278.8
(22) Date of filing: 19.01.2001
(51) Int. Cl.: B65G 1/04

(54) **Semiconductor product container stocker**

(71) Applicant: Semiconductor300 GmbH & Co KG, 01099 Dresden (DE)
(72) Inventor: Lering, Michael, 91088 Bubenreuth (DE)
(74) Representative: Fischer, Volker, Dipl.-Ing.

(57) **Abstract**

The invention refers to a semiconductor product container stocker (1) for stocking containers (2) for semiconductor products, the container stocker (1) comprising a stocking location having a predefined single container stocking position (3) accessible to an automated container handling system. According to the invention the container stocker (1) comprises a variable position stocking region (4) for stocking containers at variable stocking positions (5), the container stocker (1) being constructed such that in case of removal of a container from the predefined stocking position (3) by the automated container handling system a container stocked in the stocking region (4) is supplied from the stocking region (4) to the predefined stocking position (3) of the stocking location.

With the present invention prior art stockers with cinematic pin copies on each stocking position are no longer required. Furthermore, the container stocker according to the invention requires less volume and floor space.

## Description

The invention refers to a semiconductor product container stocker for stocking containers for semiconductor products, the container stocker comprising a stocking location having a predefined single container stocking position accessible to an automated container handling system.

Such stockers are required in semiconductor industry for stocking up to 10,000 pieces of semiconductor product containers. Therefore, many container stockers each comprising a large number of stocking locations are required.

In semiconductor industry, there are three requirements which result in the usage of container stockers of the kind described above.

First, one container may contain up to 25, 30 or even more semiconductor products, especially wafers up to 12 inches in diameter, each wafer plane being large enough to produce hundreds of chips. Hence, there may be a few thousand chips contained in one single container, this capital even being increased during the manufacturing process due to the price of each single chip. The high price of semiconductor products contained in a container requires safe handling and, in particular, safe stocking of containers.

Secondly, semiconductor industry is highly automated. The semiconductor product containers are handled by automated handling systems which usually are not equipped with container position detecting means. Hence, predefined container stocking positions of a great number of stocking locations are stored in a software handling program controlling an automated container handling system to access a respective stocking location.

Thirdly, due to mini-environmental wafer processing, semiconductor product containers are atmospherically isolating semiconductor products contained therein from the surrounding cleanroom atmosphere. When loading or unloading semiconductor products to processing equipment, a container is atmospherically coupled to a loadport containing a mini-environmental atmosphere of higher purity than the surrounding cleanroom atmosphere. Due to precise positioning of a container on a loadport, the container coupled to the loadport is supported by three kinematic pins granting for precise container positioning up to a certain maximum weight of the container and the semiconductor products contained therein. With view to the need of highly precisely positioned containers at the loadports, both the container handling system and the container stockers must allow for similar precision of handling and stocking. Therefore, each stocking location of a container stocker is equipped with three pins corresponding to kinematic coupling pins. Each triple of these pins is predefining one single container stocking position of the respective stocking location.

According to these requirements, such container stockers are used which are provided with a great number of triples of cinematic pin copies, each triple predefining a single container stocking location accessible to the automated handling system. Such container stockers are very expensive because they require an automated stocker handling system to access each predefined stocking location.

Further, these stockers are space-consuming as each container is stocked on a predefined stocking position and as there is an access to each stocking position, the volume of these accesses adding to the volume of the containers resting on all the other stocking positions.

It is an object of the present invention to provide a semiconductor product container stocker less expensive and space-consuming.

This object is achieved by a semiconductor product container storage as quoted above which further comprises a variable position stocking region for stocking containers at a variable stocking position and which is being constructed such that in case of removal of a container from the predefined stocking position by the automated container handling system the container stocked in the stocking region is supplied from the stocking region to the predefined stocking position of the stocking location.

According to the invention there is a stocking region not predefining single container stocking positions but being a variable position stocking region instead. When the stocking location having the predefined stocking position is occupied with a container, the automated container handling system can grab the container from the predefined stocking position.

If there is no container on the predefined stocking position as in case of removal of a container therefrom, according to the invention another container is supplied from the variable position stocking region to the predefined stocking position due to the construction of the container stocker. Its construction is such that on any container removal from the stocking location the stocking location is reoccupied with another container from the stocking region as long as there is any container in the stocking region in reserve.

In contrast to prior art container stockers requiring transfer of handling means to each predefined stocking position, it is the general idea underlying the present invention to provide only one predefined stocking position (in simplest case) and to transfer containers from other stocking positions not predefined to this predefined stocking position, the prior art motion of handling means now being replaced by the motion of the semiconductor product containers themselves. It is this concept which reduces volume and costs of the container stocker.

According to a preferred embodiment, the stocking position of the stocking location is the only predefined stocking position of the container stocker. As there are no means for predefining stocking positions required in the variable position stocking region, costs and volume of the container stocker are very low. Merely the one and only stocking location is equipped with means for predefining its stocking position. By these means, the predefined stocking position is accessible to the automated container handling system.

Preferably, the predefined stocking position of the stocking location is predefined by a triple of kinematic pin duplicates. They are copies of kinematic pins of current loadports arranged in equal manner.

Preferably, the stocking region is constructed such that containers within the stocking region are transferred towards a position next to the predefined stocking position of the stocking location. Thereby rapid reoccupying is facilitated in case of removal of a container from the predefined stocking position. Though the distance between the predefined stocking position and that position within the variable position stocking region next to the predefined stocking position may vary depending on the distance between the stocking location and the variable position stocking region, transfer of containers within the variable position stocking.region in direction to the predefined stocking position accelerates rapid reoccupying particularly in case of large variable position stocking regions designed for a great number of containers.

Preferably, the stocking region comprises inclined container ramps. By means of inclined ramps, gravity causes transfer of the containers within the variable position stocking region; belt transfers or other transport means are not required.

According to a preferred embodiment, the stocking region comprises at least one seesaw for transferring containers from the end of a container ramp to the start of another container ramp. By providing seesaws several container ramps of different directions of transfer may be combined.

Preferably, the container ramps are arranged in staircase-wise manner. This embodiment allows for compact design of the variable position stocking region with minimal floor space.

Especially in case of staircase-wise arrangement of container ramps with several container ramps upon one another, according to a preferred embodiment the stocking region comprises a container lift. The container lift loads an upper part of the stocking region with containers which then move, for instance by gravity, within the stocking region in direction to the predefined stocking position of the stocking location.

Preferably, the stocking region comprises a conveyor. Conveyors usually serve for transport of products. According to this embodiment however, a conventional conveyer is filled up with containers and hence used as a variable position stocking region, that is as a stocker serving as container reserve at a fixed stocker position.

According to another embodiment of the invention, the lift and/or the seesaw comprise a belt transfer for transferring containers. A belt transfer mounted on a seesaw may be employed for changing the transfer directions when a container passes from the end of one container ramp to the start of another container ramp of other direction or of opposite inclination compared to the first container ramp.

Preferably, each belt transfer is driven electrically or by means of compressed air.

According to preferred embodiments, the container stocker is designed for stocking front opening unified pods (FOUPs) or front opening shipping boxes (FOSBs).

Hereinbelow the invention is described with reference to the accompanying figures.
- Figure 1: illustrates a container storage according to the present invention.
- Figure 2A: schematically illustrates the transfer of a con tainer from a first container ramp to a second one by passing a seesaw.
- Figure 2B: illustrates a container on a seesaw in front-side view.

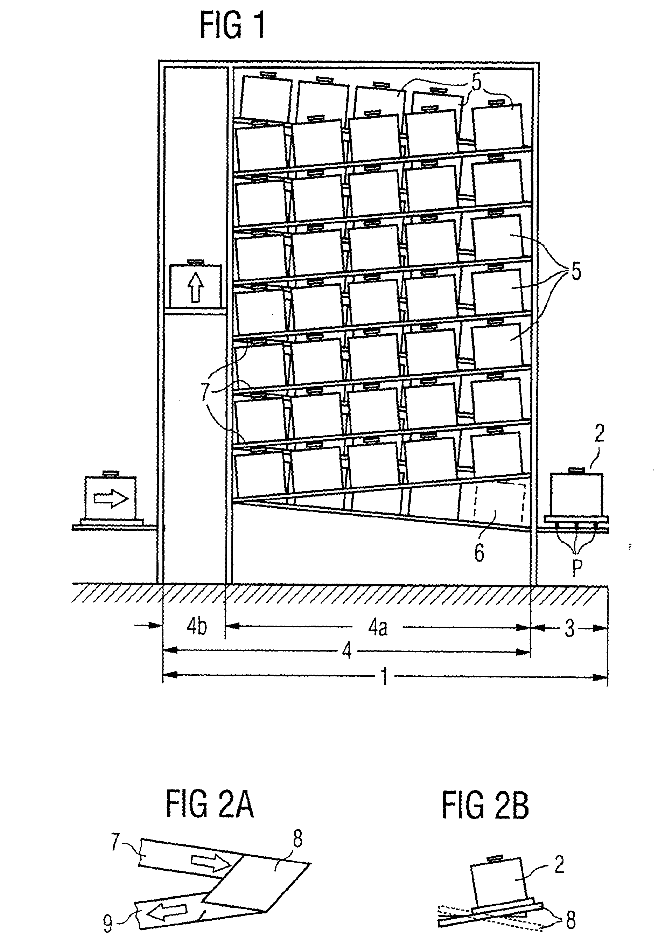

According to figure 1, the container stocker 1 comprises a stocking location having a predefined single container stocking position 3 and a variable position stocking region 4, the variable position stocking region 4 comprising a region 4a constructed of inclined container ramps 7 arranged in staircase-wise manner. At the ends of the container ramps 7, seesaws 8 not illustrated in figure 1 are provided. The container ramps and the seesaws define a passage within the variable position stocking region leading to a position 6 next to the predefined stocking position of the stocking location 3. Within the stocking region, several containers are stocked at variable container positions 5. From the left, containers are lifted by means of the container lift 4b to another part of the stocking region for loading the passage with containers.

Figure 1 illustrates the container storage just after preoccupation of the predefined stocking position of the stocking location 3. The container 2 has just been supplied from the position 6 illustrated by dashed lines to the stocking location 3, its stocking position being predefined by three kinematic pin duplicates P. Just upon reoccupation, other containers in the variable position stocking region will subsequently move in the direction of the predefined stocking position, thereby the position 6 next to the predefined stocking position being reoccupied in succession.

Figure 2a schematically illustrates the direction of transfer from a first container ramp 7 to a second container ramp 9 of opposite inclination to the first ramp 7 by means of a seesaw 8. The seesaw is tiltable between two inclination angles corresponding to the inclination of ramp 7 and that of ramp 9. Figure 2b shows the seesaw in front view, the container being in a position for transport by the second container ramp 9 and the dashed lines indicating the seesaw position corresponding to the inclination angle of the first container ramp 7. For transfer of containers from ramp 7 to ramp 9, the seesaw comprises a belt transfer not illustrated in detail. Container transfer directions on the ramps 7 and 9 and on the belt transfer of the seesaw 8 are indicated by respective arrows.

With the present invention, expensive stockers for FOUP or FOSB storage are no longer required. Instead, low-cost first-in-first-out (FIFO) stockers are provided.

## Claims

1. Container stocker (1) for stocking containers (2) for semiconductor products, the container stocker (1) comprising a stocking location having a predefined single container stocking position (3) accessible to an automated container handling system,
**characterised in that**
the container stocker (1) comprises a variable position stocking region (4) for stocking containers at a variable stocking position (5) and that the container stocker (1) is constructed such that in case of removal of a container from the predefined stocking position (3) by the automated container handling system a container stocked in the stocking region (4) is supplied from the stocking region (4) to the predefined stocking position (3) of the stocking location.

2. Container stocker according to claim 1,
**characterised in that**
the stocking position (3) of the stocking location is the only predefined stocking position of the container stocker (1).

3. Container stocker according to claim 1 or 2,
**characterised in that**
the predefined stocking position (3) of the stocking location is predefined by a triple of kinematic pin duplicates (P).

4. Container stocker according one of claims 1 to 3,
**characterised in that**
the stocking region (4) is constructed such that containers within the stocking region are transferred towards a position (6) next to the predefined stocking position (3) of the stocking location.

5. Container stocker according to claim 4,
**characterised in that**
the stocking region (4) comprises inclined container ramps (7).

6. Container stocker according to claim 5,
**characterised in that**
the stocking region (4) comprises at least one seesaw (8) for transferring containers from the end of a container ramp (7) to the start of another container ramp (9).

7. Container stocker according to claim 5 or 6,
**characterised in that**
the container ramps (7) are arranged in staircase-wise manner.

8. Container stocker according to one of claims 1 to 7,
**characterised in that**
the stocking region (4) comprises a container lift (4b).

9. Container stocker according to one of claims 1 to 8,
**characterised in that**
the stocking region (4) comprises a conveyer (4a).

10. Container stocker according to claim 6 or 8,
**characterised in that**
the container lift (4b) and/or the seesaw (8) comprise a belt transfer for transferring containers (2).

11. Container stocker according to claim 10,
**characterised in that**
each belt transfer is driven electrically or by means of compressed air.

12. Container stocker according to one of claims 1 to 11,
**characterised in that**
the container stocker is designed for stocking front-opening unified pods (FOUPs).

13. Container stocker according to one of claims 1 to 11,
**characterised in that**
the container stocker is designed for stocking front-opening shipping boxes (FOSBs).
